## Europäisches Patentamt

## European Patent Office

## Office européen des brevets

(11) Veröffentlichungsnummer: **0 176 915**
**B1**

(12) **EUROPÄISCHE PATENTSCHRIFT**

(45) Veröffentlichungstag der Patentschrift: **27.12.90**

(51) Int. Cl.⁵: **H 03 F 1/30, H 03 F 3/45**

(21) Anmeldenummer: **85112051.9**

(22) Anmeldetag: **24.09.85**

(54) **Schaltungsanordnung zum Nullpunktabgleich eines integrierten Operationsverstärkers.**

(30) Priorität: **26.09.84 DE 3435321**

(43) Veröffentlichungstag der Anmeldung:
**09.04.86 Patentblatt 86/15**

(45) Bekanntmachung des Hinweises auf die
Patenterteilung:
**27.12.90 Patentblatt 90/52**

(84) Benannte Vertragsstaaten:
**DE GB**

(56) Entgegenhaltungen:
**DE-A-1 963 423**
**GB-A-2 111 780**

**PATENT ABSTRACTS OF JAPAN, Band 3, Nr. 44,
14. April 1979, Seite 105 E104 & JP-A-54-22 812
AUTOMATIK, 15. Jahrgang, Nr. 2, Februar 1970,
Seiten 47-50, Heidelberg, DE; H. DIETZENBACH:
"Operationsverstärker - vielseitige
Fertigbausteine für die Automation (II)"**

(73) Patentinhaber: **Siemens Aktiengesellschaft
Wittelsbacherplatz 2
D-8000 München 2 (DE)**

(72) Erfinder: **Lechner, Robert, Dipl.-Ing.
Haidfeldstrasse 5
D-8156 Otterfing (DE)**
Erfinder: **Sealer, David, Dr. Phil.
7620 Kevin Drive
Dallas Texas 75248 (US)**

Courier Press, Leamington Spa, England.

**Beschreibung**

Die Erfindung betrifft eine Schaltungsanordnung zum Nullpunktabgleich eines integrierten Operationsverstärkers mit einem Nullabgleichkondensator, der durch entsprechende Betätigung von Halbleiterschaltern jeweils während einer Abgleichphase in einen zwischen dem invertierenden Eingang des Operationsverstärkers, der über einen Rückkopplungswiderstand mit dessen Ausgang in Verbindung steht, und einem Bezugspotential führenden Schaltungspunkt liegenden Schaltungszweig eingeschaltet ist und während der darauffolgenden Betriebsphase unter Polungsumkehr zwischen diesen Bezugspotentialpunkt und den nicht invertierenden Eingang des Operationsverstärkers gelegt ist.

Mit einer Schaltungsanordnung der genannten Art ist es möglich, den Offset-Fehler von Operationsverstärkern so zu kompensieren, daß am invertierenden Differenzverstärkereingang des Operationsverstärkers Nullpotential vorliegt. Dennoch wird eine Ausgangsspannung von der Nullpunktsabgleichschaltung abgegeben, die von Null abweicht und in ihrer Größe einer sogenannten Offset-Spannung entspricht.

Mit der vorgenannten bekannten Schaltungsanordnung wird während einer Abgleichphase über einen Rückkopplungszweig ein Nullabgleichkondensator soweit vorgeladen, daß er in der anschließenden Betriebsphase, in der der Kondensator unter Polumkehr an den anderen Verstärkereingang gelegt ist, die Offset-Spannung bzw. der entsprechenden Nullpunktfehler kompensiert.

Wenn für die Umschaltung zwischen der Abgleichphase und der Betriebsphase Halbleiterschalter Verwendung finden, dann wird wegen des Einflusses parasitärer Kapazitäten wenigstens eines dieser Schalter, die die Ladung des Nullabgleichkondensators verfälschen, die Genauigkeit der solcher Art erzielten Kompensation verringert. Eine Vergrößerung der Kapazität des Nullabgleichkondensators in einem derartigen Ausmaß, daß dieser Effekt vernachlässigbar ist, würde zu Baugrößen führen, die im Zusammenhang mit integrierten Schaltungen nicht mehr tragbar sind.

Die geschilderte Aufladung des Nullabgleichkondensators erfolgt in der Regel periodisch und jeweils während einer gegenüber der Betriebszeitsphase nur kurzen Zeitspanne. Da die Offset-Spannung keine konstante Größe ist, hat dies zur Folge, daß der Nullabgleichkondensator unter Umständen Ladungen aufnimmt, die nicht über die ganze Betriebsphase hinweg den Störverhältnissen entspricht, was Quelle einer weiteren Ungenauigkeit dieser Kompensationsschaltung ist.

Darüber hinaus ist auch mit Störeinstreuungen auf den Ausgang des Operationsverstärkers zu rechnen, die dann über den Rückkopplungsweg die Aufladung des Nullabgleichkondensator beeinflussen und damit ebenfalls dazu beitragen, daß die Kompensation nicht die gewünschte Genauigkeit aufweist.

Einen ähnlichen Effekt haben Störungen, die auf die Erdleitung einer solchen Schaltungsanordnung eingekoppelt werden. Beim Übergang der Abgleichphase in die Betriebsphase, ergibt sich außerdem bei der bekannten Schaltungsanordnung jeweils ein Sprung der Ausgangsspannung des Operationsverstärkers, was ebenfalls unerwünscht ist.

Aufgabe der vorliegenden Erfindung ist es daher, eine Schaltungsanordnung zum Nullpunktabgleich der obengennanten Art dahingehend zu verbessern, daß die erläuterten Ungenauigkeiten und Störmöglichkeiten weitgehend eliminiert sind.

Erfindungsgemäß wird dies dadurch erreicht, daß zwischen dem invertierenden Eingang des Operationsverstärkers und dem Bezugspotentialpunkt ein RC-Glied, dessen Widerstand am invertierenden Operationsverstärkereingang liegt, und zwischen dem nicht invertierenden Eingang des Operationsverstärkers und dem Bezugspotentialpunkt ein Kondensator fest angeschlossen ist, und daß der Widerstand des RC-Gliedes und der letzgenannte Kondensator Elementes des genannten Schatungszweiges sind, zwischen die der Nullabgleichkondensator in der Nullabgleichphase gelegt ist.

Durch das erfindungsgemäße vorgesehene RC-Glied werden schnelle Offset-Spannungsänderungen weitgehend gedämpft. Langsam nicht ändernde Störeinflüsse werden durch die Mittelwertbildung im Verhältnis der Kapazitäten des Nullabgleichkondensators und des zwischen dem invertierenden Eingang und dem Bezugspotentialpunkt liegenden fest angeschalteten Kondensator über mehrere Abgleichphasen gemittelt.

Wenn gemäß einer weiteren Ausgestaltung der Erfindung zum Herbeiführen der genannten Einschalt- und Umschaltvorgänge zwei mit ihren Hauptstromstrecken in Reihe geschaltete und zwischen dem Verbindungspunkt des Widerstandes und des Kondensators des RC-Gliedes und dem Bezugspotentialpunkt angeschlossene Halbleiterschalter verwendet sind, die sich bezüglich ihres inneren Aufbaus, der Führung ihrer Anschlußverdrahtung und der Zeitdauer und relativen Lage ihrer Ansteuerimpulse soweit wie möglich gleichen, ist der Einfluß parasitärer Kapazitäten der Halbleiterschalter in noch besserem Ausmaß verringert.

Noch eine andere Ausgestaltung der Erfindung ist gekennzeichnet durch einen jeweils während des Einschaltbetriebs aktivierten Halbleiterschalter, dessen Hauptstromstrecke dem zwischen dem nicht invertierenden Eingang des Operationsverstärkers und dem Bezugspotentialpunkt fest angeschlossenen Kondensator parallel geschaltet ist. Es wird also mit Hilfe dieses Schalters eine evtl. noch auf dem Kondensator befindliche Ladung zu Null gemacht, so daß bei der erneuten Abgleichphase die Aufladung des Nullabgleichkondensators von der Vorgeschichte der Schaltungsanordnung unabhängig ist.

Nachstehend wird die Erfindung anhand eines Ausführungsbeispiels unter Bezugnahme auf eine Figur noch näher erläutert.

Der Operationsverstärker, dessen Nullpunktabgleich mit Hilfe der erfindungsgemäßen Schaltungsanordnung vorgenommen werden soll, ist in der Fig. mit OP bezeichnet. Der invertierende Eingang dieses Operationsverstärkers wird im dargestellten Beispiel von einem Digital-Analog-Wandler DAC mit einem Eingangssignal beaufschlagt. Der Ausgang des Operationsverstärkers ist über einen Rückkopplungswiderstand Rr mit dem invertierenden Eingang verbunden.

Zwischen dem invertierenden Eingang und einem Bezugspotential führenden Schaltungspunkt (Masse) ist ein RC-Glied angeschlossen, das aus einem hochohmigen Widerstand R3 (beispielsweise 100 kOhm), der durch einen Feldeffekttransistor gebildet sein kann, und mit seinem einen Abschluß an dem invertierenden Eingang des Operationsverstärkers liegt, sowie aus einem Kondensator C3 besteht, dessen dem Widerstand abgewendeter Anschluß an dem Bezugspotentialpunkt liegt. Zwischen dem nicht invertierenden Eingang des Operationsverstärkers und dem Bezugspotentialpunkt ist ein Kondensator C1 fest angeschlossen.

Zwischen dem nicht invertierenden Eingang des Operationsverstärkers und dem Verbindungspunkt des Widerstandes R3 und des Kondensators C3 liegt über einen Halbleiterschalter T1 ein Kondensator C2, bei dem es sich um den eigentlichen Nullabgleichkondensator handelt.

Die Belegung des Kondensators, die über den Halbleiterschalter T1 mit dem Widerstand R3 verbindbar ist, kann außerdem über einen zweiten Halbleiterschalter T2 mit dem Bezugspotentialpunkt verbunden werden.

Der Kondensator C1 ist durch einen weiteren Halbleiterschalter T3 überbrückbar. Die Kapazitätswerte der Kondensatoren tragen beispielsweise C1=10 pF, C2=1 pF, C3=10 pF.

Nachstehend wird noch kurz auf die Betriebsweise der dargestellten Schaltungsanordnung eingegangen.

Bei einer Inbetriebnahme der Schaltungsanordnung wird zunächst der Halbleiterschalter T3 geschlossen, so daß eine evtl. Ladung des Kondensators C1 abfließen kann. Im Zuge einer Abgleichphase, die sich insbesondere bei dem beispielsweise vorgesehenen Betrieb im Zusammenhang mit einem Digital-Analog-Konverter eines PCM-Systems periodisch in Abständen von 125 µs wiederholt, wird durch Anlegen eines Steuerimpulses der Halbleiterschalter T1 beispielsweise für 4 µs geschlossen. Die Halbleiterschalter T2 und T3 sind während dieser Zeitspanne geöffnet. Es wird sich daher vom Ausgang des Operationsverstärkers her über den Rückkopplungswiderstand Rr und über das RC-Glied R3/C3 der Abgleichkondensator entsprechend der Offset-Spannung aufladen, wobei das RC-Glied dafür sorgt, daß Spannungsspitzen gedämpft werden.

In der anschließenden Betriebsphase ist der Halbleiterschalter T1 geöffnet, der Halbleiterschalter T2 dagegen geschlossen, so daß der aufgeladene Nullabgleichkondensator C2 nun unter Polungsumkehr zwischen dem Bezugspotentialpunkt und dem nicht invertierenden Eingang des Operationsverstärkers liegt und damit die Offset-Spannung kompensiert wird, also sofern der Digital-Analog-Wandler keine Eingangsspannung für den Operationsverstärker liefert eine nur vernachläßigbar kleine Ausgangsspannung am Operationsverstärkerausgang abgegeben wird. Da über mehrere solcher Ableich/Betriebsphasen hinweg die wirksame Kompensationsspannung im Verhältnis der Kapazitätswerte C1:C2 gemittelt wird, sind langsam sich ändernde Störeinflüsse weitgehend unwirksam gemacht.

Eine weitere Verbesserung läßt sich dadurch erreichen, daß man die Abgleichphase nicht zyklisch sondern entsprechend einer Zufallsfolge auftreten läßt.

Wie schon angedeutetwerden die Auswirkungen parasitärer Kapazitäten der Halbleiterschalter, insbesondere des den Nullabgleichkondensator mit dem Bezugspotentialpunkt verbindenden Halbleiterschalters T2 dann besonders klein gehalten, wenn die Halbleiterschalter T1 und T2 sowohl bezüglich des Aufbaus, also was ihre Größe und Kristallausrichtung anbetrifft, als auch bezüglich ihre Anschlußverdrahtung identisch bzw. symmetrisch sind. Dasselbe gilt für die Ansteuerimpulse zur Betätigung dieser Halbleiterschalter, deren zeitliche Lage und Zeitdauer sich entsprechen muß.

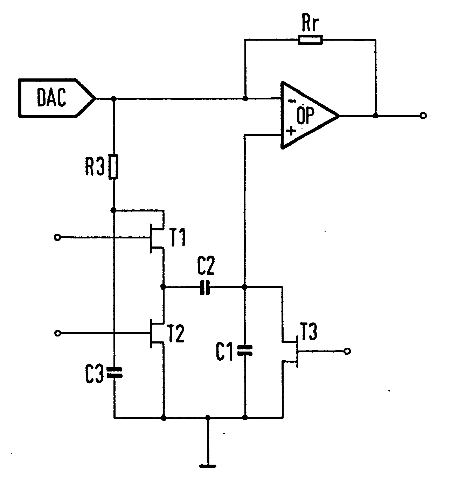

**Patentansprüche**

1. Schaltungsanordnung zum Nullpunktabgleich eines integrierten Operationsverstärker (OP) mit einem Nullabgleichkondensator (C2), der durch entsprechende Betätigung von Halbleiterschaltern jeweils während einer Abgleichphase in einen zwischen dem invertierenden Eingang (−) des Operationsverstärkers (OP), der über einen Ruckkopplungswiderstand (Rr) mit dessen Ausgang in Verbindung steht, und einem Bezugspotential führenden Schaltungspunkt liegenden Schaltungszweig eingeschaltet ist und während der darauffolgenden Betriebsphase unter Polungsumkehr zwischen diesem Bezugspotentialpunkt und dem nicht invertierenden Eingang des Operationsverstärkers gelegt ist, dadurch gekennzeichnet, daß zwischen dem invertierenden Eingang (−) des Operationsverstärkers (OP) und dem Bezugspotentialpunkt ein RC-Glied (R3/C3), dessen Widerstand (R3) am invertierenden Operationsverstärkereingang (−) liegt und zwischen dem nicht invertierenden Eingang (+) des Operationsverstärkers und dem Bezugspotentialpunkt ein Kondensator (C1) fest angeschlossen ist, und daß der Widerstand (R3) des RC-Gliedes (R3/C3) und der letztgenannte Kondensator (C1) Elemente des genannten Schaltungszweiges sind, zwischen die der Nullabgleichkondensator (C2) in der Nullabgleichphase gelegt ist.

2. Schaltungsanordnung nach Anspruch 1, dadurch gekennzeichnet, daß zum Herbeiführen der genannten Einschalt- und Umschaltvorgänge zwei mit ihren Hauptstromstrecken in Reihe geschaltete und zwischen dem Verbindungspunkt des Widerstandes (R3) und des Kondensators (C3) des RC-Gliedes (R3/C3) und dem Bezugspotentialpunkt angeschlossene Halbleiterschalter (T1, T2) verwendet sind, die sich bezüglich ihres inneren Aufbaus, der Führung ihrer Anschlußverdrahtung und der Zeitdauer und relativen Lage ihrer Ansteuerimpulse soweit wie möglich gleichen.

3. Schaltungsanordnung nach Anspruch 1 oder 2, gekennzeichnet durch einen jeweils während des Einschaltbetriebs aktivierten Halbleiterschalter (T3), dessen Hauptstromstrecke dem zwischen dem nicht invertierenden Eingang (+) des Opera-tionsverstärkers (OP) und dem Bezugspotential-punkt fest angeschlossenen Kondensator (C1) parallel geschaltet ist.

4. Schaltungsanordnung nach einem der vor-hergehenden Ansprüche, dadurch gekennzeich-net, daß die Abgleichphase sich periodisch wiederholend eingestellt wird.

5. Schaltungsanordnung nach einem der Ansprüche 1 bis 3, dadurch gekennzeichnet, daß die Abgleichphase gemäß einer Zufallsfolge wiederholt wird.

## Revendications

1. Montage pour la correction du décalage du point zéro d'un amplificateur opérationnel (OP) avec un condensateur de correction du point zéro (C2), qui pendant une phase de correction, est inséré dans une branche de montage située entre un point du montage, qui est porté au potentiel de référence, et l'entrée inverseuse (−) de l'amplificateur opérationnel (OP) qui est reliée à la sortie de ce deriner par l'intermédiaire d'une résistance de rétroaction (Rr), et reliée, pendant la phase opératoire suivante, avec inversion de la polarité, entre ledit point porté au potentiel de référence et l'entrée non inverseuse de l'amplificateur opérationnel, caractérisé par le fait qu'entre l'entrée inverseuse (−) de l'amplificateur opérationnel (OP) et ledit point porté au potentiel de référence, est prévu un circuit RC (R3/C3) dont la résistance (R3) est relié à l'entrée inverseuse (−) de l'amplificateur opérationnel, alors qu'un condensateur (C1) est monté fixe entre l'entrée non inverseuse (+) de l'amplificateur opérationnel et ledit point porté au potentiel de référence, et que la résistance (R3) du circuit (R3/C3) et le condensateur (C1) mentionné en dernier lieu sont des éléments de ladite branche de circuit et entre lesquels se situe le condensateur de correction du point zéro, pendant la phase de correction du zéro.

2. Montage selon la revendication 1, caractérisé par le fait que pour la réalisation desdits processus de branchement et d'inversion, on utilise des interrupteurs à semiconducteurs (T1, T2) dont les pistes du courant principal sont montées en série et sont reliées entre le point de liaison de la résistance (R3) et du condensateur (C3) du circuit RC (R3/C3) et le point porté au potentiel de référence, lesdits interrupteurs à semiconducteurs étant autant que possible identiques du point de vue de leur constitution interne, du passage de leur câblage de branchement et de la durée et de la position relative de leurs impulsions d'attaque.

3. Montage selon la revendication 1 ou 2, caractérisé par un interrupteur à semiconducteurs (T1) qui est activé pendant son branchement, et dont la voie du courant principal est montée en parallèle par rapport au condensateur (C1) relié de façon fixe, entre l'entrée non inverseuse (+) de l'amplificateur opérationnel et le point porté au potentiel de référence.

4. Montage selon l'une des revendications précédentes, caractérisé par le fait que la phase de correction est réglée de façon à se répéter périodiquement.

5. Montage selon l'une des revendications 1 à 3, caractérisé par le fait que la phase de correction est répétitive suivant une succession aléatoire.

## Claims

1. Circuit arrangement for offset correction of an integrated operational amplifier (OP) having an offset correction capacitor (C2) which, by appropriately operating semi-conductor switches in each case during a correction phase is switched into a circuit branch located between the interting input (−) of the operational amplifier (OP), which is connected to its output via a feedback resistor (Rr), and a circuit point carrying reference potential, and during the subsequent operating phase is connected with polarity reversal between this reference potential point and the non-inverting input of the operational amplifier, characterized in that between the inverting input (−) of the operational amplifier (OP) and the reference potential point an RC section (R3/C3), the resistor of which (R3) is located at the inverting operational amplifier input (−), is permanently connected, and between the non-inverting input (+) of the operational amplifier and the reference potential point a capacitor (C1) is permanently connected, and in that the resistor (R3) of the RC section (R3/C3) and the last-mentioned capacitor (C1) are elements of the said circuit branch between which the offset correction capacitor (C2) is placed in the offset correction phase.

2. Circuit arrangement according to Claim 1, characterized in that, in order to produce the said switching-on and switching-over processes, two semi-conductor switches (T1, T2), which are connected in series with their main current paths and are connected between the junction of the resistor (R3) and the capacitor (C3) of the RC section (R3/C3) and the reference potential point, are used which are as identical to each other as possible with respect to their internal structure, the course of their connecting wiring and the duration and relative position of their drive pulses.

3. Circuit arrangement according to Claim 1 or 2, characterized by a semi-conductor switch (T1) which is in each case activated during the switching on mode and the main current path of which is connected in parallel with the capacitor (C1) which is permanently connected between the non-inverting input (+) of the operational amplifier (OP) and the reference potential point.

4. Circuit arrangement according to one of the preceding claims, characterized in that the correction phase is periodically repeated.

5. Circuit arrangement according to one of Claims 1 to 3, characterized in that the correction phase is repeated in accordance with a random sequence.